Europäisches Patentamt

European Patent Office

Office européen des brevets

(19)

(11) Veröffentlichungsnummer : **0 528 785 A1**

## (12) EUROPÄISCHE PATENTANMELDUNG

(21) Anmeldenummer : **92890181.8**

(22) Anmeldetag : **11.08.92**

(51) Int. Cl.$^5$ : **H01J 37/30**

(30) Priorität : **20.08.91 AT 1634/91**

(43) Veröffentlichungstag der Anmeldung :
**24.02.93 Patentblatt 93/08**

(84) Benannte Vertragsstaaten :
**AT BE CH DE ES FR GB IT LI NL SE**

(71) Anmelder : **IMS Ionen Mikrofabrikations
Systeme Gesellschaft m.b.H.
Schreygasse 3
A-1020 Wien (AT)**

(72) Erfinder : **Stengl, Gerhard, Dr.
Umberg 31
A-9241 Wernberg, Kärnten (AT)**
Erfinder : **Chalupka, Alfred, Dr.
Pezzlgasse 15/9
A-1170 Wien (AT)**
Erfinder : **Vonach, Herbert, Prof. Dr.
Martinstrasse 83
A-3400 Klosterneuburg (AT)**

(74) Vertreter : **Itze, Peter, Dipl.-Ing. et al
Patentanwälte Casati, Wilhelm, Dipl.-Ing. Itze,
Peter, Dipl.-Ing. Amerlingstrasse 8
A-1061 Wien (AT)**

(54) Ionenoptisches Abbildungssystem.

(57)    Die Erfindung betrifft ein ionenoptisches Abbildungssystem, in dem eine auf einer Maske M befindliche Struktur in Gestalt einer oder mehrerer Öffnungen über ein Linsensystem auf einen Wafer W abgebildet wird, mit einer zwischen der Maske M und dem Wafer W angeordneten Kombination aus zwei Sammellinsen L1, L2, wobei die Maske M jeweils annähernd in der gegenstandsseitigen Brennebene der auf die Maske M folgenden Sammellinse L1 und der Wafer W in der Umgebung der bildseitigen Brennebene der auf die Maske M folgenden zweiten Sammellinse L2 positioniert ist und bevorzugt die gegenstandsseitige Brennebene der zweiten auf die Maske M folgenden Sammellinse L2 den Crossover der ersten auf die Maske M folgenden Sammellinse L1 enthält, wobei die Kombination aus zwei Sammellinsen von einer insbesondere beschleunigenden EINZEL-Linse und einer beschleunigenden asymmetrischen EINZEL-Linse gebildet wird, wobei die insbesondere beschleunigende EINZEL-Linse auf die Maske folgt und die beschleunigende asymmetrische EINZEL-Linse vor dem Wafer angeordnet ist.

EP 0 528 785 A1

TABELLE

Ionenoptische Eigenschaften des untersuchten Ionenprojektionslithographiesystems

bestehend aus einer EINZEL-Linse (1. Sammellinse L1) und einer asymmetrischen

beschleunigenden EINZEL-Linse (2. Sammellinse L2)

**beschleunigende EINZEL-Linse (L1):**

| | |
|---|---|
| Skalierung | 1,23 |
| Spannungsverhältnis | 7,10 |

**asymmetrische beschleunigende EINZEL-Linse (L2):**

| | |
|---|---|
| Skalierung | |
| Spannungsverhältnisse: | |
| U2/U1 | 7,6 |
| U3/U3 | 3,8 |
| Abstand Maske - Wafer (m) | 3,01 |
| Verkleinerungsfaktor | 3 |
| max. Verzeichnung ($\mu$m)[1] | 0,11 |
| max. chromatische Verbreiterung ($\mu$m)[2] | $\pm 0,07$ |
| (Ionenenergie)$_{Wafer}$/(Ionenenergie)$_{Maske}$ | 3,8 |

[1] Für Bildfeld 20 x 20 mm²,
   max. Abweichung irgendeines Bildpunktes von der idealen Abbildung

[2] Für Energieverschmierung der Ionen am Ionenquellenausgang
   $\Delta E/E = \pm 0,001$, wobei E die Energie der Ionen am Ausgang der Ionenquelle ist

FIG. 1

Die Erfindung betrifft ein ionenoptisches Abbildungssystem, in dem eine auf einer Maske befindliche Struktur in Gestalt einer oder mehrerer Öffnungen über ein Linsensystem auf einen Wafer abgebildet wird, mit einer zwischen der Maske und dem Wafer angeordneten Kombination aus zwei Sammellinsen, wobei die Maske jeweils annähernd in der gegenstandsseitigen Brennebene der auf die Maske folgenden Sammellinse und der Wafer in der Umgebung der bildseitigen Brennebene der auf die Maske folgenden zweiten Sammellinse positioniert ist und bevorzugt die gegenstandsseitige Brennebene der zweiten auf die Maske folgenden Sammellinse den Cross-over der ersten auf die Maske folgenden Sammellinse enthält. Unter den verschiedenen Schritten, die zur Herstellung von Halbleiterbauelementen ausgeführt werden müssen, ist der Lithographieschritt besonders wichtig. Vereinfacht ausgedrückt, beginnt jeder Lithographieschritt mit dem Aufbringen einer dünnen Schicht aus lichtempfindlichem Material, dem sogenannten Photoresist oder kurz "Resist" auf einen Wafer, insbesondere aus Silizium. Ein Lithographiegerät projiziert dann die auf der Maske vorhandene Struktur auf den mit dem Resist versehenen Wafer, wobei die Ausdehnung dieser projizierten Struktur auf dem Wafer meist sehr viel kleiner ist als der Wafer. Anschließend an die Projektion wird der Wafer verschoben und dieselbe Struktur der Maske auf eine andere Stelle des Wafers projiziert. Dieser Vorgang des Projizierens und Verschiebens wird solange wiederholt, bis die gesamte Waferfläche genutzt ist. Durch nachfolgende Entwicklung des Resists erhält man auf dem Wafer das gewünschte Muster in Form von resistfreien Stellen. Der Wafer kann dann in weiteren Schritten irgendeinem der bekannten Bearbeitungsvorgänge wie Ätzen, Ionenimplantation oder Aufbringen und Diffusion von Dotierungsmaterial unterzogen werden. Nach diesen weiteren Schritten wird der Wafer kontrolliert, wieder mit Resist überzogen und die gesamte vorerwähnte Schrittfolge etwa 8 - 15 mal wiederholt, bis schließlich eine schachbrettartige Anordnung von identischen Mikroschaltkreisen auf dem Wafer erzeugt ist.

Die meisten heute verwendeten Projektionslithographieverfahren verwenden Licht zur Bestrahlung des Resists, aber das Bedürfnis nach kleineren Strukturen und höherer Dichte der Komponenten der Mikroschaltkreise hat dazu geführt, intensiv nach anderen Bestrahlungsmethoden zu suchen, die in ihrer Auflösung nicht wie bei Anwendung von Licht auf dessen relativ große Wellenlänge beschränkt sind. Große Anstrengungen wurden unternommen, um Röntgenstrahlen in Lithographiegeräten zu verwenden, während andere Verfahren wie z.B. die Ionenlithographie, zwar einige, aber doch wesentlich weniger Beachtung erfahren haben.

Das Hauptziel der vorliegenden Erfindung ist es, ein ionenoptisches Abbildungssystem zu verbessern, das die Beschränkungen und Nachteile der existierenden Systeme weitgehend vermeidet bzw. überwindet. Hiezu wird für ein Abbildungssystem der eingangs erwähnten Art vorgeschlagen, daß die Kombination aus zwei Sammellinsen von einer insbesondere beschleunigenden EINZEL-Linse und einer beschleunigenden asymmetrischen EINZEL-Linse gebildet wird, wobei die insbesondere beschleunigende EINZEL-Linse auf die Maske folgt und die beschleunigende, asymmetrische EINZEL-Linse vor dem Wafer angeordnet ist.

Bei einer EINZEL-Linse handelt es sich um ein System von drei koaxialen rotationssymmetrischen Elektroden, von denen sich die erste und dritte auf dem gleichen Potential und die Mittelelektrode auf einem davon verschiedenen Potential befindet. Werden die Ionen beim Eintritt in die Linse zunächst beschleunigt und anschließend in der zweiten Linsenhälfte wieder auf die ursprüngliche Energie abgebremst, spricht man von einer beschleunigenden EINZEL-Linse. Insgesamt ändert sich jedoch die Teilchenenergie beim Durchgang durch eine EINZEL-Linse nicht, da Anfang und Ende stets auf dem gleichen Potential liegen. Eine EINZEL-Linse ist asymmetrisch, wenn an den drei Elektroden drei verschiedene Potentiale angelegt sind. In diesem Fall bewirkt der Durchgang der Teilchen durch die Linse eine Änderung der Teilchenenergie, wobei die asymmetrische EINZEL-Linse beschleunigend ist, wenn durch den Übergang vom Potential der ersten Elektrode zum Potential der dritten Elektrode die Ionenenergie vergrößert wird.

Asymmetrische EINZEL-Linsen besitzen kleinere Bildfehler als Immersionslinsen mit gleicher Anfangs- und Endspannung und gleichem Elektrodendurchmesser. Da nun die sphärische Aberration bei einer asymmetrischen EINZEL-Linse um etwa eine Größenordnung kleiner gemacht werden kann als bei den zuvor erwähnten Immersionslinsen, kann durch die Verwendung einer asymmetrischen EINZEL-Linse als vor dem Wafer angeordneter Linse, in dem erfindungsgemäß ausgestalteten ionenoptischen Abbildungssystem eine Reduktion der die Abbildungsqualität bestimmenden restlichen Verzeichnung am Ort des Verzeichnungsminimums von ebenfalls etwa einer Größenordnung erzielt werden. Dies folgt aus der Tatsache, daß der am Ort des Verzeichnungsminimums maßgebende Koeffizient für die Verzeichnung fünfter Ordnung sich im wesentlichen als Summe von Produkten der Verzeichnungskoeffizienten dritter Ordnung der beiden Sammellinsen des Abbildungssystems zusammensetzt (Konsequenz der Multiplikation der beiden Transfermatrizen) und daher die Reduktion von Fehlern auch nur in einer Linse eine entsprechende Verbesserung der Abbildungsqualität des Gesamtsystems ergibt.

Durch Verwendung von EINZEL-Linsen (Dreielementlinse) können zwei Spannungsverhältnisse (U2/U1, U3/U1) frei gewählt werden, nämlich das Verhältnis zwischen den Spannungen an der mittleren und der eingangsseitigen Elektrode und jenes zwischen der ausgangsseitigen und der eingangsseitigen Elektrode, und es ergibt sich ein zusätzlicher Freiheitsgrad für die Optimierung des Gesamtsystems, der den Entwurf von ionenoptischen Abbildungssystemen mit speziellen Eigenschaften sehr erleichtert bzw. überhaupt erst möglich macht. So wird etwa bei Verwendung einer Immersionslinse, die bloß zwei Elektroden besitzt, im allgemeinen die Optimierungsbedingung für das Gesamtsystem bei vorgegebener Linsengeometrie nur für ein bestimmtes Verhältnis zwischen den Spannungen an den beiden Elektroden der Immersionslinse erfüllt werden können, d.h. das Verhältnis Ionenenergie am Wafer zu Ionenenergie an der Maske ist dadurch festgelegt. Bei Verwendung einer asymmetrischen EINZEL-Linse und Variation der beiden vorgenannten Spannungsverhältnisse an den Elektroden kann jedoch ein optimiertes System (Minimum von Verzeichnung und chromatischer Aberration am Ort des Gaußschen Bildpunktes der Maske sowie telezentrischer Strahlengang) über einen weiten Bereich von Spannungsverhältnissen zwischen den Spannungen an den beiden endständigen Elektroden und damit Ionenenergieverhältnissen zwischen Wafer und Maske erreicht werden.

Mit Hilfe der erfindungsgemäßen Kombination zweier Sammellinsen wird ermöglicht, zur Bestrahlung des Resist relativ niederenergetische Ionen zu verwenden. Damit können bei wesentlich höherer Tiefenschärfe im Vergleich zu Licht Submikrostrukturen unter 0,25 μm realisiert werden und der Nachteil der hiezu ebenfalls möglichen Röntgenlithographie, nämlich die Erzeugung von Defekten im Siliziumsubstrat weitgehend vermieden werden, weil Ionen der hier vorgeschlagenen Energie bereits in z.B. 0,5 μm starken Resistschichten gestoppt werden können.

Bei der praktischen Realisierung des erfindungsgemäßen Ionenprojektionslithographiesystems wird die "Beleuchtung" der Maske nicht unmittelbar durch die Ionenquelle ausgeführt, sondern durch ein vorgeschaltetes Beleuchtungssystem erfolgen, um die Lage des für die Beleuchtung der Maske maßgeblichen virtuellen Quellpunktes beliebig variieren zu können und hiebei den Abstand zwischen der körperlichen, realen Ionenquelle und dem Wafer von nicht größer als etwa 3 - 4 m einzuhalten, was aus konstruktiven Gründen angestrebt wird. Für den virtuellen Quellpunkt sind aber aus zwei Gründen wesentlich größere Distanzen erforderlich. Zunächst ist zur Erzielung optimaler Verzeichnungsfreiheit (s. das Ausführungsbeispiel) ein annähernd paralleler Strahlauffall auf die Maske notwendig, was Abstände zwischen der virtuellen Ionenquelle und der Maske von einigen 10 m erfordert, und weiters ist wegen der aus Stabilitätsgründen notwendigen Maskenstärke von einigen μm es erforderlich, daß Ionen nahezu senkrecht auf die Maske auftreffen. Hieraus ergibt sich eine Beschränkung des Auftreffwinkels der Ionen auf die Maske auf etwa 0, 1 °, um kleine Strukturen (z.B. 5μm breite Schlitze) auf der Maske ohne merkliche Abschattung auf den Wafer zu projizieren. Auch dies führt bei einer vorgesehenen Maskengröße von 60 x 60 mm² zu einem ähnlichen Mindestabstand der virtuellen Ionenquelle von der Maske.

Ferner ist zu beachten, daß jede Ionenquelle außer den erwünschten Ionen noch eine Reihe unerwünschter Ionensorten emittiert, für deren Ausblendung vor dem Wafer zu sorgen ist. Um die vorerwähnten Auflagen zu erreichen, wird für eine Beleuchtungseinrichtung für die Maske in einem ionenoptischen Abbildungssystem, das insbesondere für den Einsatz in einem ionenoptischen Abbildungssystem erfindungsgemäßer Ausgestaltung vorgesehen ist und das mit einer Ionenquelle, einer gegebenenfalls von einer (beschleunigenden oder verzögernden) EINZEL-Linse gebildeten sogenannten Ionenquellenlinse sowie einem der Ionenquellenlinse folgenden, insbesondere als ExB-Filter ausgebildeten Massenseparator versehen ist, erfindungsgemäß vorgeschlagen , daß dem Massenseparator eine sogenannte Beleuchtungslinse folgt, welche alternativ als Immersionslinse oder als beschleunigende oder als verzögernde EINZEL-Linse ausgebildet oder von einem bzw. auch mehreren Soleniden gebildet ist. Bei diesem Abbildungssystem wird durch die EINZEL-Linse kurzer Brennweite die Ionenquelle in das Zentrum des Massenseparators, eines Wien-Filters (ExB-Filter), d.i. eine Anordnung, in der ein homogenes elektrisches Feld einem dazu senkrechten homogenen Magnetfeld überlagert wird, abgebildet. Für Ionen der gewünschten Masse heben sich die von den beiden Feldern erzeugten Kräfte exakt auf, bei allen anderen Ionen ist dies nicht der Fall, und sie werden durch Ablenkung aus dem Strahl entfernt. Anschließend erzeugt die Beleuchtungslinse ein virtuelles Bild der Ionenquelle, mit dem Abstände der virtuellen Ionenquelle von der Maske realisiert werden können, die im Bereich von einigen 10 bis einigen 100 m liegen können.

Dabei muß die Beleuchtungslinse eine ähnlich hohe Qualität haben wie die beiden Sammellinsen, da ihre Verzeichnung im Zusammenwirken mit der Verzeichnung der Abbildungslinsen zu zusätzlichen Verzeichnungen 5. Ordnung führt, die die Gesamtverzeichnung wesentlich verschlechtern kann. Als Beleuchtungslinse ist dabei die Verwendung einer elektrostatischen EINZEL-Linse von etwa Dimension und Qualität der Abbildungslinsen besonders bevorzugt.

Die Erfindung wird nachstehend anhand der Zeichnung beispielsweise näher erläutert, in welcher weitere für die Erfindung wesentliche Details dargestellt sind. Es zeigen,

Fig. 1 schematisch den Strahlengang in einem Ionenstrahlprojektionslithographiesystem mit zwei Sammellinsen,

Fig. 2 ein System analog Fig. 1, wobei in vollen Linien der Strahlengang für ideale, verzeichnungsfreie Linsen und in unterbrochenen Linien der Strahlengang unter Berücksichtigung der Verzeichnung dargestellt ist,

Fig. 3 ein System analog Fig. 1, in welchem in vollen Linien der Strahlengang eingetragen ist, wie er bei Sollenergie $E_0$ auftritt, mit unterbrochenen Linien, hingegen der Strahlengang bei von der Sollenergie um $\Delta E_0$ abweichender (verminderter) Energie, zur Veranschaulichung der Korrektur des chromatischen Bildfehlers,

Fig. 4 eine Beleuchtungseinrichtung in schematischer Darstellung, wie sie für die erfindungsgemäße Kombination von zwei Sammellinsen eingesetzt werden kann,

Fig. 5 schematisch die Lage der Startpunkte von Ionen auf der Maske, deren Bewegung durch das erfindungsgemäße System aus zwei Sammellinsen untersucht wurde, und

Fig. 6 schematisch den grundsätzlichen Aufbau einer EINZEL-Linse in axialem Längsschnitt, in Ausbildung als Rotationskörper.

In der Zeichnung ist mit M eine Maske bezeichnet, welche die abzubildende Struktur aufweist, die auf einen Wafer W abgebildet wird.

Die Maske M, welche die abzubildende Struktur in Form von Öffnungen in einer Folie (z.B. aus Silizium) aufweist, wird von einer Ionenquelle Q mit sehr geringer virtueller Quellengröße ( 10 μm) beleuchtet und befindet sich annähernd in der Brennebene einer ersten Sammellinse L1. Diese Sammellinse L1 erzeugt einen Cross-over (reelles Bild der Ionenquelle Q) an der Stelle C, kurz hinter ihrem bildseitigen Brennpunkt, sofern der Abstand zwischen der Ionenquelle Q und der auf die Maske M folgenden Sammellinse L1 groß ist gegenüber der Brennweite dieser Sammellinse L1. Der gegenstandsseitige Brennpunkt der vor dem Wafer W angeordneten zweiten Sammellinse L2 befindet sich am Ort des Cross-over C. Damit verlassen die Stahlen die Sammellinse L2 sämtlich achsparallel und man erhält ein annähernd telezentrisches System. Dieses hat den Vorteil, daß sich der Abbildungsmaßstab bei kleinen Verschiebungen des Wafers W in Richtung der ionenoptischen Achse nicht ändert.

Dieses System besitzt unabhängig von der Realisierung der beiden Sammellinsen L1 und L2 die folgenden Eigenschaften:

a) Das die Strukturen der Maske auflösende Bildfeld wird durch die Kombination der beiden Sammellinsen L1 - L2 in der Umgebung des bildseitigen Brennpunktes der vor dem Wafer W angeordneten Sammellinse L2 abgebildet, wenn sie sich, wie vorgesehen, in der Umgebung des gegenstandsseitigen Brennpunktes der auf die Maske M folgenden Sammellinse L1 befindet.

b) Das Strahlenbündel erhält durch die auf die Maske M folgende Sammellinse L1 eine tonnenförmige Verzeichnung (Beteich A), die nach dem Cross-over C in eine kissenförmige Verzeichnung übergeht (Bereich B).

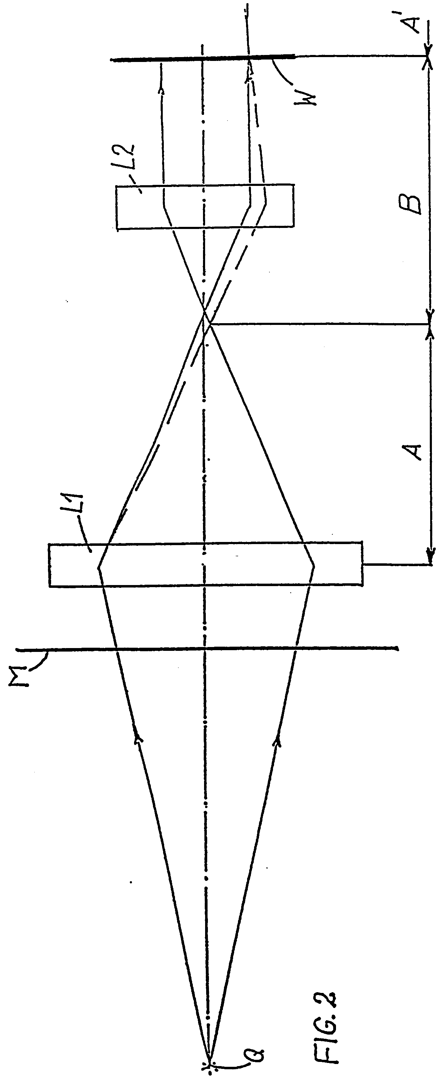

Fig. 2 veranschaulicht nun, daß durch die Verzeichnung der vor dem Wafer W angeordneten Sammellinse L2 die Stahlen eine zusätzliche Ablenkung erhalten, die diese kissenförmige Verzeichnung (Bereich B) reduziert und wieder in eine tonnenförmige Verzeichnung (Bereich A') überführt. Dabei gibt es hinter der vor dem Wafer W angeordneten Sammellinse L2 eine Ebene, in der sich die durch beide Sammellinsen L1 und L2 hervorgerufenen Verzeichnungen kompensieren. Dies gilt allerdings nur für den Verzeichnungsfehler dritter Ordnung, es bleibt der (sehr viel kleinere) Verzeichnungsfehler fünfter Ordnung, d.h. die Verzeichnung verschwindet nicht zur Gänze, sondern besitzt lediglich ein ausgeprägtes Minimum. Bei vorgegebener Bildfeldgröße ist diese Restverzeichnung umgekehrt proportional zur fünften Potenz des Abstandes Maske - Wafer bei gleichmäßiger Änderung aller Dimensionen im optischen System zwischen Maske und Wafer.

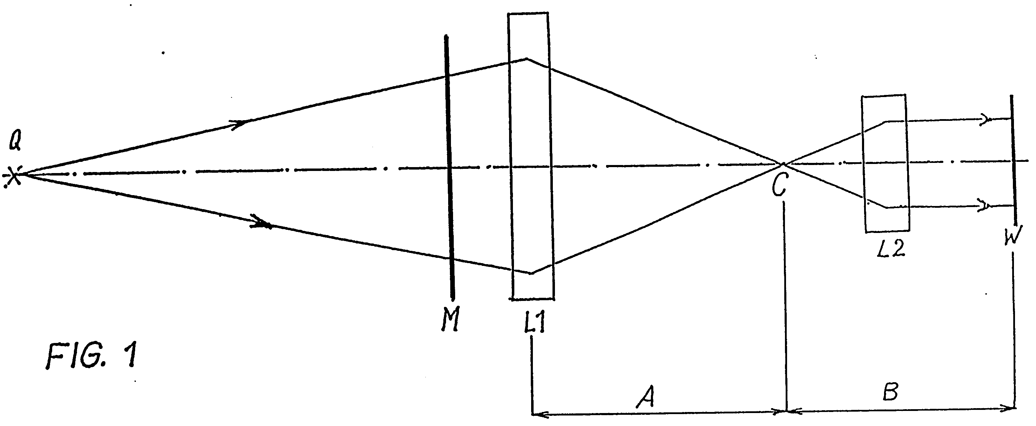

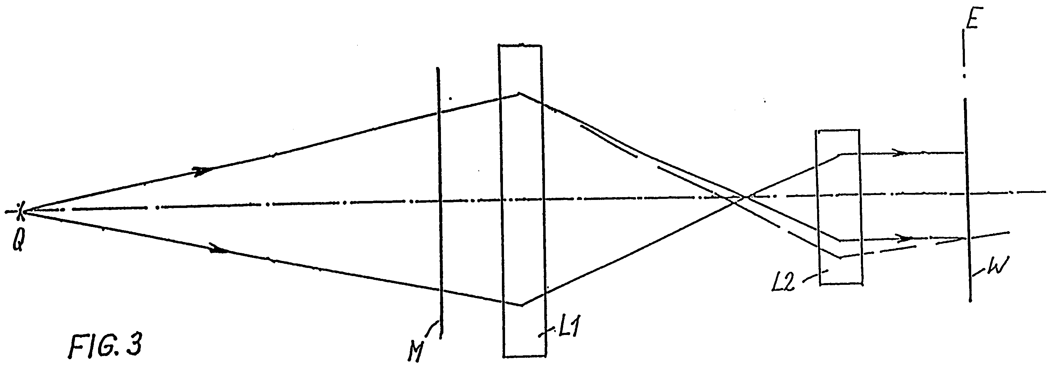

c) In der Anordnung nach Fig. 1 ergibt sich (wie in Fig. 3 ersichtlich gemacht) auch für den chromatischen Fehler eine Kompensation der Wirkungen der beiden Sammellinsen L1 und L2 für eine bestimmte Bildebene hinter der vor dem Wafer W angeordneten Sammellinse L2. Ein Strahl (in Fig. 3 in unterbrochenem Linienzug dargestellt) mit etwas kleinerer Energie $E_0 - \Delta E_0$ als der Sollenergie $E_0$ wird in der auf die Maske M folgenden ersten Sammellinse L1 stärker abgelenkt, trifft infolgedessen die vor dem Wafer W angeordnete zweite Linse L2 in größerer Achsenferne als der (in vollem Linienzug dargestellte) Sollstrahl und wird daher aus diesem Grund und wegen seiner geringeren Energie um sovielmehr zurückgelenkt, daß er in einer bestimmten Entfernung hinter der vor dem Wafer W angeordneten Sammellinse L2 den Sollstrahl trifft. In dieser Ebene E verschwindet offensichtlich der chromatische Fehler erster Ordnung. Es verbleibt auch hier ein Restfehler, der chromatische Fehler 2. Ordnung, d.h. ein Fehler proportional zum Quadrat der Energieabweichung vom Sollstrahl.

d) Die drei relevanten Ebenen, die Gaußsche Bildebene der Maske M, die Ebene minimaler Verzeichnung und die Ebene E minimalen chromatischen Fehlers werden im allgemeinen nicht zusammenfallen. Durch geeignete Wahl der Sammellinsen L1 und L2 und der Ionenquellenlage kann jedoch erreicht werden, daß unter Beibehaltung des parallelen Strahlenganges die genannten drei Ebenen zusammenfallen. Wird der Wafer W dort angeordnet, wo die drei Ebenen zusammenfallen, so bewirkt dies, daß in der Bildebene der Maske (d.i. der Ort des Wafers W) sowohl ein Minimum der Verzeichnung als auch ein Minimum des chromatischen Fehlers vorhanden ist.

e) Der Abbildungsmaßstab, d.h. der Verkleinerungsfaktor, mit dem die Struktur der Maske auf den Wafer W abgebildet wird, ist annähernd gegeben durch das Verhältnis der bildseitigen Brennweite der auf die Maske M folgenden ersten Sammellinse L1 zur gegenstandsseitigen Brennweite der vor dem Wafer W angeordneten zweiten Sammellinse L2. Durch Skalierung (ähnliche Vergrößerung oder Verkleinerung von L2) ist es daher möglich, den Verkleinerungsfaktor des Abbildungssystems unter Beibehaltung aller übrigen Eigenschaften (gleichzeitige Korrektur von Verzeichnung und des chromatischen Fehlers am Gaußschen Bildpunkt der Maske) zu verändern.

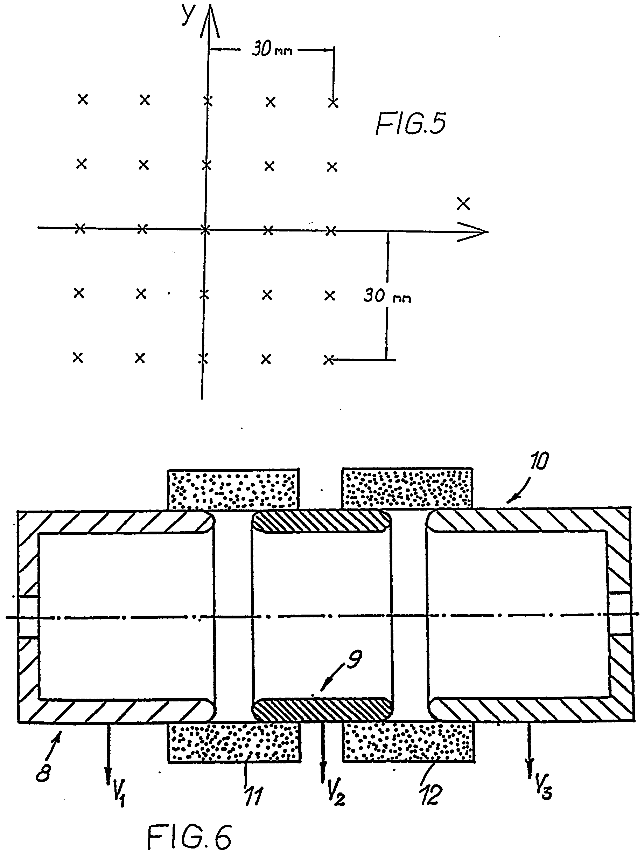

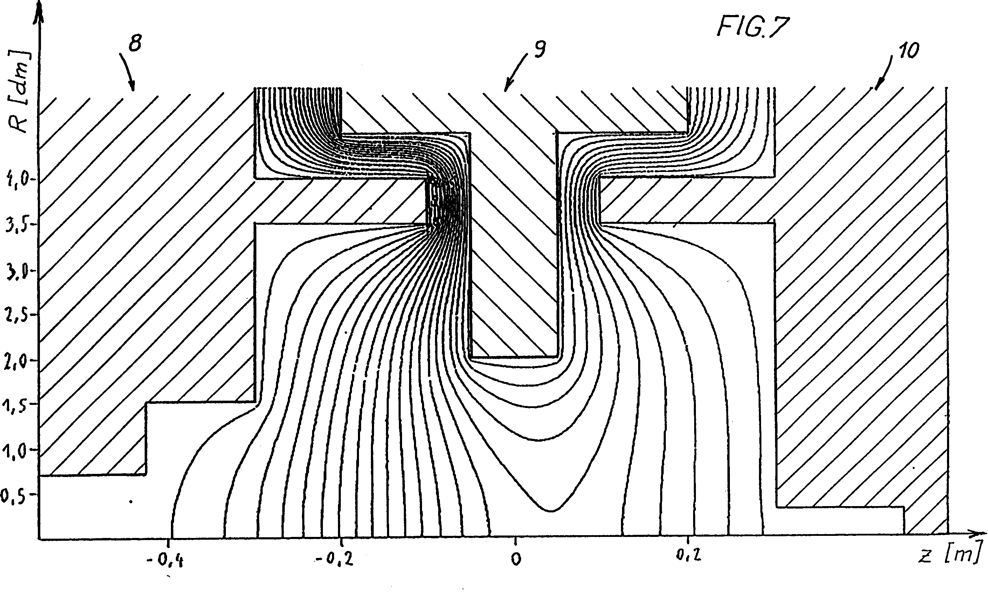

Fig. 6 zeigt den grundsätzlichen Aufbau einer EINZEL-Linse. Eine solche Linse besitzt drei Elektroden 8, 9 und 10, die voneinander durch Hülsen 11 und 12 aus isolierendem Material getrennt sind. Bei einer "normalen" EINZEL-Linse liegt die Elektrode 9 auf einem Potential, das unterschiedlich von den Potentialen V1 und V3 der endständigen Elektroden 8 und 10 ist. Sind die Potentiale V1 und V3 gleich und werden die Ionen unter dem Einfluß des Potentials V2 der mittleren Elektrode 9 beschleunigt, wird von einer beschleunigenden EINZEL-Linse (EL$^+$) gesprochen. Sind die Potentiale V1 und V3 der endständigen Elektroden 8 und 10 voneinander verschieden, handelt es sich um eine asymmetrische EINZEL-Linse. Auch bei einer solchen asymmetrischen EINZEL-Linse können abhängig vom Potential an der mittleren Elektrode die Ionen beim Durchgang durch die Linse beschleunigt (oder verzögert) werden. Solche Linsen werden dann als asymmetrische, beschleunigende EINZEL-Linsen (AEL$^+$) bzw. asymmetrische, verzögernde EINZEL-Linsen (AEL-) bezeichnet.

Beispiel:

Als Ausführungsbeispiel wurde die Kombination einer EINZEL-Linse mit einer asymmetrischen EINZEL-Linse mit 100 % Überspannung (U2/U3 = 2,0, wobei U2 die Spannung an der mittleren und U3 an der ausgangsseitigen Elektrode der EINZEL-Linse ist) numerisch mit hoher Präzision durchgerechnet.

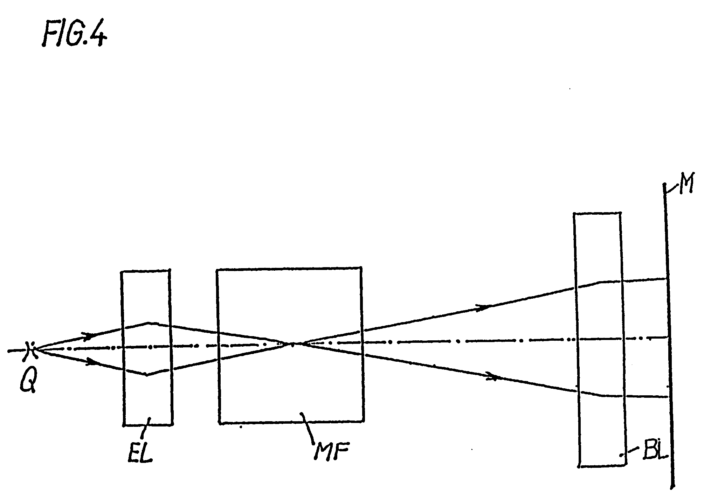

Dabei wurde die Abbildung des mit Strukturen versehenen Bildfeldes von 60 x 60 mm$^2$ einer Maske mit Verkleinerung 3 auf eine Waferfläche von 20 x 20 mm$^2$, entsprechend den in Zukunft zu erwartenden Anforderungen der Halbleiterindustrie, untersucht und annähernd parallele Beleuchtung der Maske, realisiert durch eine elektrostatische "Beleuchtungslinse" BL zwischen der Quelle Q und der Maske M (siehe Fig. 4) angenommen.

Die Berechnung und Optimierung des genannten Linsensystems wurde dabei in folgenden Schritten durchgeführt:

1) Berechnung der Potentialverteilung bei gegebener Linsengeometrie aus der Potentialgleichung für die beiden zu kombinierenden Linsen. Für die EINZEL-Linse genügte dazu ein Berechnungsvorgang. Für die asymmetrische EINZEL-Linse mußten die Berechnungen für eine Reihe von unterschiedlichen Spannungen an den beiden endständigen Elektroden durchgeführt werden.

2) Berechnung der Linsenparameter erster und dritter Ordnung als Funktion des Span-nungsverhältnisses zwischen den Elektroden der Linse (bzw. im Falle der asymmetrischen EINZEL-Linse der beiden Spannungsverhältnisse). Dies geschah folgendermaßen:

Zunächst wurde aus den aus der Potentialgleichung berechneten Potentialwerten das elektrische Feld bestimmt, wobei sich zeigte, daß zur Erzielung ausreichender Genauigkeit eine zweidimensionale kubische Interpolation notwendig war. Dann wurde eine Anzahl von Teilchenbahnen durch die Linsen (gleichmäßig verteilt über den interessanten Ausleuchtungsbereich der Linsen) durch numerische Integration verfolgt. Aus den Positionen der Bahnen am Linsenende kann dann die Transfermatrix in erster, dritter und fünfter Ordnung bestimmt werden, wobei auch die Fehler der Matrixelemente bestimmt werden. Berechnungen dieser Art mit verschiedenen Einschußenergien der Ionen ergeben die Transfermatrix für verschiedene Spannungsverhältnisse. Als Ergebnis dieser Folge von Rechnungen wird für die untersuchten Linsen die Transfermatrix in fünfter Ordnung als Funktion des Spannungsverhältnisses (bzw. der beiden Spannungsverhältnisse bei asymmetrischen EINZEL-Linen) erhalten.

3) Nach der Standardmethode der Matrizenmultiplikation wird der Strahlengang durch Systeme, bestehend aus zwei Linsen und Driftstrecken, von einem gegebenen Anfangsort (Maske) zu einem gegebenen Endort (Wafer) und damit die Transfermatrix berechnet (siehe Fig. 1). Dabei werden die Matrizen für die Linsen als Funktion des Spannungsverhältnisses an den Elektroden aus den Ergebnissen von Schritt 2) übernommen.

Aus den ermittelten Transfermatrizen können die Bildorte für eine Reihe von Starpunkten auf der Maske errechnet werden, wobei in den Rechnungen stets die aus Fig. 5 ersichtliche Anordnung der Startpunkte gewählt wurde. Die Richtung der von diesen Startpunkten ausgehenden Strahlen ist dabei durch die angenommene Lage der Ionenquelle sowie die Lage und Stärke der Beleuchtungslinse bestimmt (s. Fig. 4) und kann ebenfalls berechnet werden. Aus der Lage der Bildpunkte können dann durch einen linearen Fit mittlere und maximale Werte der Verzeichnung aus den Abweichungen der berechneten Bildorte von den entsprechenden Fitgeraden ermittelt werden. Weiterhin werden solche Bildortberechnungen auch für Energien durchgeführt, die sich um einen kleinen Betrag ($\Delta$E) von der gewählten Sollenergie (E) unterscheiden, woraus dann die Werte ur den chromatischen Fehler des Linsensystems bestimmt werden können.

4) Das erfindungsgemäße Abbildungssystem (die Kombination der beiden Sammellinsen) kann hinsichtlich der Bildfehler optimiert werden. Durch Iteration kann eine Optimierung bezüglich gleichzeitiger Minimierung von Verzeichnung und chromatischen Fehlern vorgenommen und dabei auf Wunsch noch eine Reihe von Nebenbedingungen erfüllt werden.

Bei dem hier erwähnten Ausführungsbeispiel wurde dabei wie folgt vorgegangen:

1) Nebenbedingungen, die zu erfüllen waren:

1.a) Paralleler Strahlengang am Ausgang des Abbildungssystems (d.i. vor dem Wafer nach der dem Wafer vorgelagerten Sammellinse L2).

1.b) Gaußsche Abbildung der Maske M auf den Wafer W.

1.c) Abbildungsmaßstab Maske - Wafer beträgt 1/3.

2) Folgende Größen wurden (unter Einhaltung der vorgenannten Nebenbedingungen) zum Zwecke der Bildfehlerminimierung variiert:

2.a) Abstand zwischen der Maske M und der auf diese folgenden Linse L1,

2.b) Abstand zwischen den beiden Sammellinsen L1 und L2,

2.c) Abstand zwischen dem Wafer W und der dem Wafer W vorrgelagerten Sammellinse L2 und

2.d) Skalierungsfaktor, d.h. ähnliche Vergrößerung bzw. Verkleinerung durch die dem Wafer W vorgelagerte Sammellinse L2.

3) Zur weiteren Optimierung wurden die Spannungsverhältnisse zwischen den Elektroden der beiden Sammellinsen L1 und L2 variiert.

Das Ergebnis dieser Berechnungen ist in der angeschlossenen Tabelle zusammengestellt und läßt sich folgendermaßen zusammenfassen:

Die 60 x 60 mm² Maske läßt sich mit Verkleinerung 3 auf dem Wafer abbilden und an diesem Bildort kann gleichzeitig ein Minimum der Verzeichnung und der Bildunschärfe infolge des chromatischen Fehlers (Unschärfe der Ionenenergie) erreicht werden. Die maximale Verzeichnung an diesem Ort (infolge Bildfehler 5. Ordnung) bleibt im gesamten Bildfeld $\leq$ 0, 12 $\mu$m, die Bildunschärfe $\leq$ 0,07 $\mu$m bei einer angenommenen Maschinenlänge (Abstand Maske - Wafer von drei Meter).

Vergleicht man dies mit den Angaben in der US-PS 4 985 634, so erkennt man unmittelbar die durch die Verwendung einer asymmetrischen EINZEL-Linse im erfindungsgemäßen System erzielbare Verbesserung.

Für die in der vorerwähnten US-PS beschriebene Maschine wird angegeben, daß für eine Maschinenlänge von 2,1 m und ein Bildfeld von 10 x 10 mm² die maximale Verzeichnung kleiner 0,2 $\mu$m erreicht wird. Zum Vergleich der beiden Anordnungen müssen die Verzeichnungswerte auf gleiche Bildfeldgrößen bezogen werden. Durch Ähnlichkeitstransformation sieht man sofort, daß für ein Bildfeld von 20 x 20 mm² das Ionenprojektionslithographiesystem nach dem genannten US-Patent für eine maximale Verzeichnung von 0,4 $\mu$m eine Länge von 4,2 m haben müßte (ähnliche Vergrößerung des Gesamtsystems Faktor 2). Durch die vorgeschlagene Verwendung der asymmetrischen EINZEL-Linse als zweite Sammellinse L2 kann auch die Länge des Ionenprojektionslithographiesystems um 30 % reduziert und gleichzeitig die Verzeichnung um einen Faktor 4 verringert werden. Dieser Unterschied kann in vielen Fällen maßgebend für die Entscheidung für die Verwendung eines Ionenprojektionslithographiesystems sein.

Soferne als Maske eine solche mit nur einer Apertur verwendet wird, können mit den erfindungsgemäßen Linsenkombinationen Systeme aufgebaut werden, die einen Einzelstrahl relativ niedriger Energie bei hoher Auflösung liefern, mit dem Reparaturen an Masken und Chips bzw. Modifikationen an Chips und Masken vorgenommen werden können.

## Patentansprüche

1. Ionenoptisches Abbildungssystem, in dem eine auf einer Maske befindliche Struktur in Gestalt einer oder mehrerer Öffnungen über ein Linsensystem auf einen Wafer abgebildet wird, mit einer zwischen der Maske und dem Wafer angeordneten Kombination aus zwei Sammellinsen, wobei die Maske jeweils annähernd in der gegenstandsseitigen Brennebene der auf die Maske folgenden Sammellinse und der Wafer in der Umgebung der bildseitigen Brennebene der auf die Maske folgenden zweiten Sammellinse positioniert ist und bevorzugt die gegenstandsseitige Brennebene der zweiten auf die Maske folgenden Sammellinse den Crossover der ersten auf die Maske folgenden Sammellinse enthält, dadurch gekennzeichnet, daß die Kombination aus zwei Sammellinsen von einer insbesondere beschleunigenden EINZEL-Linse und einer beschleunigenden asymmetrischen EINZEL-Linse gebildet wird, wobei die insbesondere beschleunigende EINZEL-Linse auf die Maske folgt und die beschleunigende asymmetrische EINZEL-Linse vor dem Wafer angeordnet ist.

2.  Beleuchnngseinrichnng für die Maske in einem ionenoptischen Abbildungssystem, insbesondere nach Anspruch 1, mit einer Ionenquelle, einer gegebenenfalls von einer EINZEL-Linse gebildeten sogenannten Ionenquellenlinse sowie einem der Ionenquellenlinse folgenden, insbesondere als ExB-Filter ausgebildeten Massenseparator, dadurch gekennzeichnet, daß dem Massenseparator eine sogenannte Beleuchnngslinse folgt, welche alternativ als Immersionslinse oder als beschleunigende oder als verzögernde EINZEL-Linse ausgebildet oder von einem oder mehreren Soleniden gebildet ist.

FIG. 1

FIG.2

EP 0 528 785 A1

FIG.3

FIG.4

*FIG.5*

$y$

30 mm

$x$

30 mm

*FIG.6*

10

9

8

11

$V_1$

$V_2$

12

$V_3$

FIG.7

Europäisches
Patentamt

# EUROPÄISCHER RECHERCHENBERICHT

Nummer der Anmeldung

EP 92 89 0181

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | EP-A-0 344 646 (IMS IONEN MIKROFABRIKATIONS SYSTEME GMBH.) <br> * Seite 2, Zeile 25 – Zeile 42 * <br> * Seite 7, Zeile 54 – Seite 8, Zeile 43 * <br> * Seite 12, Zeile 3 – Zeile 37 * <br> * Seite 13, Zeile 21 – Zeile 41 * <br> * Seite 19, Zeile 17 – Zeile 25 * <br> * Abbildungen 2A,4,6,7 * <br> --- | 1,2 | H01J37/30 |
| A | EP-A-0 281 549 (IMS IONEN MIKROFABRIKATIONS SYSTEME GMBH) <br> * Spalte 3, Zeile 31 – Zeile 63; Abbildung 1 * <br> --- | 1,2 | |
| A | JOURNAL OF VACUUM SCIENCE AND TECHNOLOGY: PART B. <br> Bd. 6, Nr. 3, Juni 1988, NEW YORK US <br> Seiten 966 – 973 <br> D.H. NARUM ET AL. 'A variable energy focused ion beam system for in situ microfabrication' <br> * Seite 968, rechte Spalte – Seite 969, linke Spalte; Abbildung 2 * <br> ----- | 1 | |

**RECHERCHIERTE SACHGEBIETE (Int. Cl.5 )**

H01J

Der vorliegende Recherchenbericht wurde für alle Patentansprüche erstellt

| Recherchenort | Abschlußdatum der Recherche | Prüfer |
|---|---|---|
| DEN HAAG | 25 SEPTEMBER 1992 | SCHAUB G.G. |